# EUROPÄISCHE PATENTSCHRIFT

(11) **EP 1 118 261 B1**
(45) Veröffentlichungstag und Bekanntmachung des Hinweises auf die Patenterteilung: **21.05.2003**
(21) Anmeldenummer: 99955765.5
(22) Anmeldetag: 22.09.1999
(51) Int. Cl.: H05K 13/04

(54) **HANDHABUNGS- UND MONTAGESCHUTZ**
HANDLING AND ASSEMBLY PROTECTIVE COVER
PROTECTION POUR LA MANIPULATION ET LE MONTAGE

(30) Priorität: 28.09.1998 DE 19844461
(43) Veröffentlichungstag der Anmeldung: 25.07.2001
(73) Patentinhaber: Infineon Technologies AG, 81669 München (DE)
(72) Erfinder: WINTERER, Jürgen, 93186 Pettendorf (DE); STADLER, Bernd, D-93093 Donaustauf (DE)
(74) Vertreter: Epping Hermann & Fischer
(86) Internationale Anmeldenummer: DE9903032
(87) Internationale Veröffentlichungsnummer: WO00019798

(56) Entgegenhaltungen:
- EP-A- 0 548 583
- EP-A- 0 716 483

## Beschreibung

Die Erfindung liegt auf dem Gebiet der Handhabungs- und Montagetechnik für sensible Bauteile, insbesondere oberflächenmontierbare Drucksensoren für Fahrzeug-Airbags. Derartige Sensoren weisen eine berührungssensible Oberseite auf, die von einer Gelabdeckung über dem eigentlichen Halbleiterchip gebildet ist. Insbesondere bei der Montage derartiger Bauteile auf einer Leiterplatte ist ein Berühren der Gelabdeckung nicht auszuschließen. Berührungen können jedoch die einwandfreie Funktion eines derartigen sicherheitskritischen Bauteils beeinträchtigen, was in vielen Anwendungsfällen nicht tolerierbar ist.

Es sind zwar vielfältige Verpackungen für empfindliche elektronische Bauelemente bekannt, die insbesondere als Blisteroder sogenannte Gurtverpackungen gestaltet sind. Eine derartige, aus der WO 97/04632 bekannte Gurtverpackung umfaßt einen verschließbaren Napf, in dem das Bauteil stoßgeschützt gelagert werden kann. Dazu sind die Seitenwände des Napfes als stoßabsorbierende Federelemente ausgeformt. Der Fußpunkt der Seitenwände liegt dabei tiefer als der Napfboden, wodurch das in den Napf eingebrachte Bauteil in dem Verpackungsgurt gegen mechanische Belastungen und durch eine obere Deckfolie gegen Berührungen geschützt ist.

Allerdings ist dieser Schutz des Bauteils nur während der Lagerung und/oder des Transportes gegeben; jedenfalls endet der Schutz bereits zu dem Zeitpunkt, zu dem das Bauteil zur Montage oder zur individuellen Handhabung aus dem Gurtverbund entnommen werden muß.

In der EP 0 716 483 A2 ist eine Abdeckung eines Bauteiles zum Zweck der Handhabung mit einem Vakuumpositionierer angegeben, die eine Deckplatte mit ebener Oberfläche und federnden Befestigungsbeinen umfasst, die seitlich der Deckplatte im Winkel dazu angesetzt sind und am unteren Ende wulstartige Halteteile aufweisen.

Der vorliegenden Erfindung liegt daher die Aufgabe zugrunde, einen Handhabungs- und Montageschutz zu schaffen, der auch bei der individuellen Handhabung und Montage eingangs beschriebener Bauteile einen zuverlässigen Schutz der berührungssensiblen Oberseite bietet.

Diese Aufgabe wird erfindungsgemäß mit einem Handhabungs- und Montageschutz für ein Bauteil mit einer berührungssensiblen Oberseite und einem Bauteilgehäuse mit gegenüber der Oberseite tiefer liegenden Hinterschneidungen gelöst, der kappenartig ausgebildet ist und eine Deckschicht aufweist, die die berührungssensible Oberseite abdeckt, und der von der Deckschicht ausgehende Rastarme mit Rasthaken aufweist, die im auf das Bauteil aufgesetzten Zustand die Hinterschneidungen derart hintergreifen, daß sie auch nach Montage des Bauteils von diesem noch lösbar sind.

Ein wesentlicher Aspekt der Erfindung besteht darin, daß das Bauteil auch noch während der individuellen Handhabung zuverlässig geschützt ist, indem ihm vorzugsweise bis zum vollständigen Abschluß der Montage ein individueller kappenartiger Schutz zugeordnet ist. Dabei ist der Schutz derart gestaltet, daß er auch nach Vollendung der Montage noch von dem Bauteil entfernt werden kann. Dadurch ist das Bauteil vorteilhafterweise auch beim Kunden bis zum Montageende geschützt und kann dennoch durch einfachen Schnapp-Verschluß einfach mit dem Bauteil verbunden bzw. von diesem gelöst werden. Vorzugsweise ist der Schutz als Kunststoff-Spritzgußteil hergestellt und kann durch die Verwendung von thermoplastischem Kunststoff recyclebar sein.

Eine besonders bevorzugte konstruktive Ausgestaltung des erfindungsgemäßen Handhabungs- und Montageschutzes sieht vor, daß im Übergangsbereich zwischen den Rasthaken und der Deckschicht Materialausnehmungen vorgesehen sind.

Ein Ausführungsbeispiel der Erfindung wird nachfolgend anhand einer Zeichnung weiter erläutert; es zeigen:
Figuren 1 bis 3 einen erfindungsgemäßen Handhabungs- und Montageschutz in Aufsicht, Querschnitt und Unteransicht und
Figuren 4 und 5 in kleinerem Maßstab eine Seitenansicht eines Bauteils mit Handhabungs- und Montageschutz.

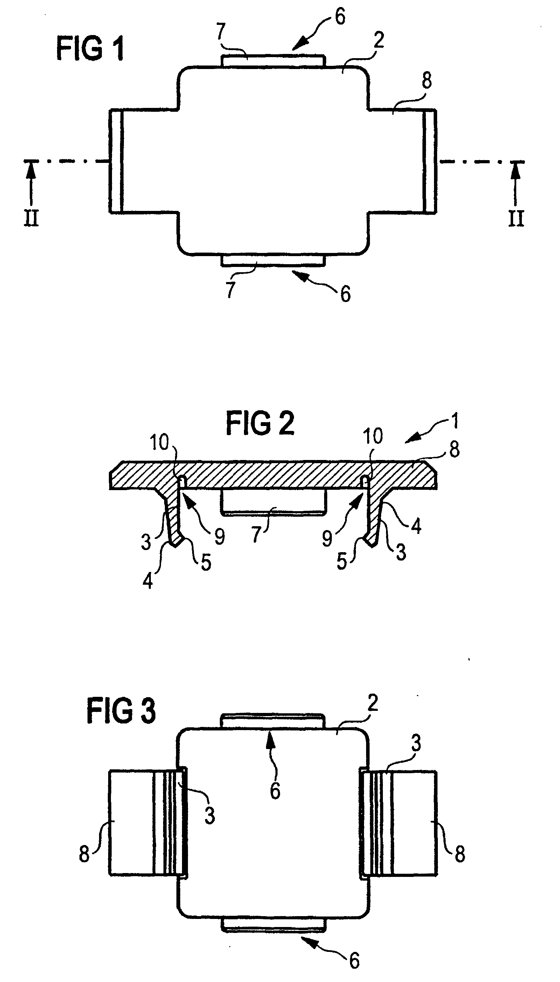

Der in den Figuren 1 bis 3 dargestellte Handhabungs- und Montageschutz ist in Form einer Kappe 1 ausgebildet (Figur 2) und weist eine Deckschicht 2 auf, die eine berührungssensible Oberseite eines Bauteils abdeckt. Von der Deckschicht 2 aus erstrecken sich Rastarme 3, deren Enden 4 mit Rasthaken 5 versehen sind. An den um jeweils 90° zu den Rasthaken versetzten Seiten 6 der Deckschicht 2 sind Haltestege 7 angeformt. Zur Handhabung, insbesondere zum Applizieren und zum Entfernen der Kappe 1 sind beiderseits der Deckschicht 2 überstehende Fortsätze 8 vorgesehen. Im Übergangsbereich 9 zwischen der Deckschicht 2 und den Rastarmen 3 sind jeweils Materialausnehmungen 10 vorgesehen, die das Auffedern der Rastarme 3 bei der Montage bzw. Demontage erleichtern. Die Federeigenschaften der Rastarme sind damit nicht nur durch das (vorzugsweise Kunststoff-) Material der Kappe bestimmt, sondern auch durch die geometrische Formgebung im Übergang zwischen Deckschicht 2 und Rastarmen 3.

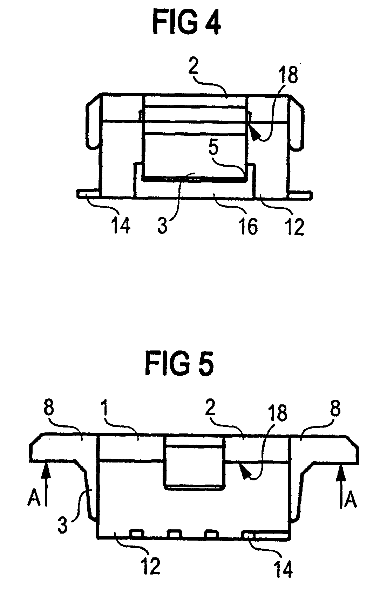

Die Figuren 4 und 5 zeigen die auf ein Bauteil 12 aufgesetzte Kappe 1, wobei das Bauteil 12 mit seinen elektrischen Anschlüssen 14 als oberflächenmontierbares Bauteil (SMD) ausgeführt ist. Die Rasthaken 5 der Rastarme 3 hintergreifen dabei Hinterschneidungen 16 des Bauteils 12 und gewährleisten damit zusammen mit den federelastischen Eigenschaften der Kappe 1 einen sicheren und zuverlässigen Sitz der Kappe auf dem Bauteil. Die Deckschicht 2 der Kappe bedeckt die berührungssensible Oberseite 18 des Bauteils 1 solange, bis das Bauteil an der gewünschten Position beispielsweise auf einer nicht dargestellten Leiterplatte aufgelötet und fixiert ist. Danach wird der Handhabungs- und Montageschutz in einfacher Weise dadurch entfernt, daß die Überstände 8 wie in Figur 5 durch Pfeile A-A angedeutet von der Oberseite 18 weg bewegt werden, so daß die Rasthaken 5 aus den Hinterscheidungen 16 hervortreten und die Verriegelung an dem Bauteil damit aufgehoben ist.

## Patentansprüche

1. Handhabungs- und Montageschutz für ein Bauteil (12) mit einer berührungssensiblen Oberseite (18) und mit gegenüber der Oberseite (18) tiefer liegenden Hinterschneidungen (16),
- der kappenartig ausgebildet ist und eine Deckschicht (2) aufweist, die die berührungssensible Oberseite (18) abdeckt,
- der von der Deckschicht (2) ausgehende Rastarme (3) mit Rasthaken (5) aufweist, die im auf das Bauteil (12) aufgesetzten Zustand die Hinterschneidungen (16) derart hintergreifen, daß sie auch nach Montage des Bauteils (12) von diesem noch lösbar sind,
- der federelastische Eigenschaften aufweist, die durch das Material und durch die geometrische Formgebung in einem Übergangsbereich (9) zwischen der Deckschicht (2) und den Rastarmen (3) bestimmt werden,
- der in dem Übergangsbereich (9) zwischen der Deckschicht (2) und den Rastarmen (3) Materialausnehmungen (10) aufweist, die ein Auffedern der Rastarme (3) bei der Montage bzw. Demontage erleichtern,
- der beiderseits der Deckschicht (2) überstehende Fortsätze (8) aufweist, die sich in der Ebene der Deckschicht (2) erstrecken, **dadurch gekennzeichnet, daß**
- die überstehenden Fortsätze (8) im Bereich der Rastarme (3) angeordnet sind, und daß der Handhabungs- und Montageschutz (12) dadurch entfernt wird, dass die Fortsätze (8) von der Oberseite (18) des Bauteils weg bewegt werden, so dass die Rasthaken (5) aus den Hinterschneidungen (16) hervortreten.

## Claims

1. Handling and mounting protection for a component (12) having a contact-sensitive upper side (18) and having undercuts (16) which are lower than the upper side (18),
- which is of a cap-like design and has a covering layer (2) which covers the contact-sensitive upper side (18),
- which has locking arms (3) which protrude from the covering layer (2) and have locking hooks (5) which, in the state in which they are fitted onto the component (12), engage behind the undercuts (16) in such a way that even after the component (12) has been mounted they can still be released from it,
- which has spring-properties which are determined by the material and by the geometric shape in a junction region (9) between the covering layer (2) and the locking arms (3),
- which has recesses (10) in the material in the junction region (9) between the covering layer (2) and the locking arms (3), which recesses (10) permit the locking arms (3) to spring open when mounting or dismounting is carried out,
- which has projections (8) which protrude on both sides of the covering layer (2) in the region of the locking arms (3) and which extend in the plane of the covering layer (2)
**characterized in that**
- the projections (8) which protrude being arranged in the region of the locking arms (3), and **in that** the handling and mounting protection (12) is removed **in that** the projections (8) are moved away from the upper side (18) of the component so that the locking hooks (5) emerge from the undercuts (16).

## Revendications

1. Elément de protection pour la manipulation et le montage d'un composant (12) ayant une face supérieure (18) sensible au toucher et ayant des contre-dépouilles (16) à un niveau plus bas par rapport à la face supérieure (18),
- qui est réalisé sous forme de cabochon et présente une couche de recouvrement (2) recouvrant la face supérieure (18) sensible au toucher,
- qui présente des bras d'encliquetage (3) issus de la couche de recouvrement (2) et comportant des crochets d'encliquetage (5) qui dans l'état appliqué sur le composant (12), s'engagent sous les contre-dépouilles (16) de manière à pouvoir être retirés du composant (12) même après que celui-ci ait été monté,
- qui présente des propriétés d'élasticité de ressort déterminées par le matériau et la forme géométrique donnée dans une zone de transition (9) entre la couche de recouvrement (2) et les bras d'encliquetage (3),
- qui présente, dans la zone de transition (9) entre la couche de recouvrement (2) et les bras d'encliquetage (3), des évidements de matière (10), facilitant le mouvement d'élasticité des bras d'encliquetage (3) lors du montage ou du démontage,
- qui présente des prolongements (8) en saillie de part et d'autre de la couché de recouvrement (2) et s'étendant dans le plan de la couche de recouvrement (2),
**caractérisé en ce que** les prolongements (8) en saillie sont disposés dans la zone des bras d'encliquetage (3), et **en ce que** l'élément de protection (12) pour la manipulation et le montage est retiré en éloignant les prolongements (8) de la face supérieure (18) du composant, de sorte que les crochets d'encliquetage (5) se dégagent des contre-dépouilles (16).
